# EUROPEAN PATENT APPLICATION

(11) **EP 1 047 120 A1**
(43) Date of publication of application: **25.10.2000**
(21) Application number: 00108402.9
(22) Date of filing: 17.04.2000
(51) Int. Cl.: H01L 21/285, H01L 33/00

(54) **Method of manufacturing an electrode in a semiconductor device**

(30) Priority: 22.04.1999 JP 11545199
(71) Applicant: SONY CORPORATION, Tokyo (JP)
(72) Inventor: Kobayashi, Toshimasa, c/o SONY Corporation, Tokyo (JP); Naganuma, Kaori, c/o SONY Corporation, Tokyo (JP)
(74) Representative: MÜLLER & HOFFMANN Patentanwälte

(57) **Abstract**

A method of manufacturing a semiconductor device capable of improving adhesibility between a semiconductor layer and an electrode, while reducing contact resistance therebetween. A resist film is formed over the entire surface of an insulating layer formed by deposition or others. Then, in the resist film, provided is an opening corresponding to the p-side electrode pattern. Meanwhile, the residue of resist may attach to the opening, but is removed through light ashing treatments using oxygen, while a p-side contact layer is protected by the insulating layer. After that, with the resist film used as a mask, an opening in the insulating layer and a p-side electrode are formed by self-aligning. Damage to the surface of the p-side contact layer can be effectively suppressed. The p-side electrode can be formed on the clean surface of the p-side contact layer.

## Description

### BACKGROUND OF THE INVENTION

### 1. Field of the Invention

The present invention relates to a method of manufacturing a semiconductor device such as a semiconductor light emitting device comprising a semiconductor layer made of a III-group nitride compound semiconductor. Specifically, the present invention relates to a method of manufacturing a semiconductor device having an electrode making contact with a semiconductor layer.

### 2. Description of the Related Art

III-group nitride compound semiconductors such as GaN, AlGaN, GaInN and AlGaInN have a characteristic of being direct transition semiconductor materials, having the bandgap Eg greater than that of III-V-group compound semiconductors of the AlGaInAs type or the AlGaInP type. Thus, these III-group nitride compound semiconductors are considered of importance as a material for a semiconductor light emitting device such as an LD (Laser Diode) emitting light with a short wave length ranging from ultraviolet rays to green lights, or an LED (Light Emitting Diode) emitting light with a wide range of wave length from ultraviolet rays to red lights. Potential applications are a high-density optical disk, a full-color display element and the like.

These III-group nitride compound semiconductors have another characteristic of a great saturation velocity in the intense electric field of GaN. Moreover, the III-group nitride compound semiconductors enable aluminum nitride (AlN) to be used for an insulating layer in the MIS (Metal-Insulator-Semiconductor) structure. This makes it possible to form a semiconductor layer and an insulating layer in a continuous process. Thus, the III-group nitride compound semiconductors are considered as significant materials for high-frequency electronic devices of high output.

In such devices as mentioned above, technology in ohmic electrodes is of extreme importance to ensure stable operations. In the related art, in an LD or an LED, a p-side ohmic electrode disposed on a semiconductor layer made of a III-group nitride compound semiconductor is made of, for example, nickel (Ni) and gold (Au), or nickel, platinum (Pt) and gold, which are stacked on the semiconductor layer in the order named. On the other hand, an n-side ohmic electrode is made of, for example, titanium (Ti) and alminum (Al), which are stacked on the semiconductor layer in the order named.

An ohmic electrode of such a configuration, however, may have a problem in adhesibility depending on the condition of formation or others, particularly in the case of a p-side electrode. Thus, electrodes may be peeled off in the course of the process of manufacturing a device or mounting a device on a package. Unstable adhesion of electrodes to a semiconductor layer causes contact resistance to increase. This results in a problem in reliability. Similar problems have also arisen in cleaving a wafer to form a mirror when fabricating an LD.

To solve these problems, a possible method is to improve adhesibility between an ohmic electrode and a semiconductor layer by changing materials for a semiconductor layer or an ohmic electrode, or changing the conditions of heat treatments in an alloying treatment of an electrode. However, the use of a material of excellent adhesibility, such as titanium, for a p-side ohmic electrode adds more than one digit to contact resistance, as compared to a configuration of the related art. This deteriorates performance or reliability of a device. Similarly, in a method of changing the conditions of heat treatments in an alloying treatment of an electrode, an attempt to improve adhesibility results in a greater contact resistance of a p-side electrode to a semiconductor layer.

Another possible alternative is to improve adhesibility by optimizing the conditions of a surface treatment of a semiconductor layer and removing completely the residue between a semiconductor layer and a p-side electrode in a Lithography process for patterning an electrode.

However, the surface treatment of a semiconductor layer for the purpose of improving adhesibility between a semiconductor layer and an ohmic electrode causes damage to the surface of a semiconductor layer. This results in problems of a decrease in the carrier density of the surface of a semiconductor layer, causing an increase in the contact resistance Rc between a semiconductor layer and an ohmic electrode. This is also the case in forming a film over the surface of a semiconductor layer by CVD (Chemical Vapor Deposition) or sputtering.

The contact resistance Rc generally has a relationship with the carrier density Na that Rc varies inversely with, for example, the order of Na⁻² (Re ∝ Na⁻²). Since it is difficult to increase the carrier density of a p-type III-group nitride compound semiconductor such as p-type GaN as compared to, for example, p-type GaAs, the contact resistance between a p-side electrode and a semiconductor layer made of a III-group nitride compound semiconductor is likely to be great. In the case with a GaAs semiconductor layer, the carrier density Na is in the order of 2×10¹⁹/cm³ and the contact resistance Rc in the order of 10⁻⁵ Ωcm can be easily attained. On the other hand, in the case with a GaN semiconductor layer, the carrier density Na is in the order of 2×10¹⁸/cm³ and the contact resistance Rc is as large as the order of 10⁻³ Ωcm in many cases. Such an increase in the contact resistance Rc may cause an operation voltage of a device to increase by about 0.1 V to several voltages in the case of, for example, a p-side electrode of an LD. This results in deterioration in reliability of a device. Moreover, even if a surface treatment such as ashing of a p-type GaAs layer has no substantial influence on characteristics of a device, a similar surface treatment of a p-type III-group nitride compound semiconductor layer causes damage to the surface of the semiconductor layer and an increase in the contact resistance Rc, which results in considerable deterioration in reliability of a device.

Furthermore, in an LD or others, if an area where an electrode is physically in contact with a surface of a semiconductor layer is larger than the area where the electrode is electrically connected to the surface of the semiconductor layer, parasitic capacity is arisen in the contact area except the area where the electrode is electrically connected to the surface of the semiconductor layer. This causes another problem of deterioration in high-frequency characteristics of a device, in addition to the problems as described above.

### SUMMARY OF THE INVENTION

The present invention is made in view of such problems. An object of the invention is to provide a method of manufacturing a semiconductor device capable of improving adhesibility between a semiconductor layer and an electrode, while reducing contact resistance therebetween.

Another object of the invention is to provide a method of manufacturing a semiconductor device capable of reducing parasitic capacity and improving high-frequency characteristics of a device.

According to the present invention, there is provided a method of manufacturing a semiconductor device comprising a semiconductor layer and an electrode making contact with the semiconductor layer, the method including steps of: forming a protective layer made of an etching resistant material, at least over a top surface of the semiconductor layer; forming a mask layer over a top surface of the protective layer and then forming an opening in the mask layer, the opening corresponding to a pattern of the electrode; removing residue generated when forming the opening in the mask layer and attached inside the opening, while the semiconductor layer is protected by the protective layer; selectively removing an area of the protective layer by using the mask layer, the area corresponding to the opening, thereby selectively exposing the semiconductor layer; and forming the electrode on the exposed surface of the semiconductor layer by using the mask layer.

In the method of manufacturing a semiconductor device according to the invention, a protective layer and a mask layer is formed in order over a top surface of a semiconductor layer, and then an opening is formed in the mask layer. After that, residue attached inside the opening in the mask layer is removed, while the semiconductor layer is protected by the protective layer. Then, the protective layer is selectively removed by using the mask layer, thereby the semiconductor layer is selectively exposed. An electrode is formed on the exposed surface of the semiconductor layer by using the mask layer.

Other and further objects, features and advantages of the invention will appear more fully from the following description.

### BRIEF DESCRIPTION OF THE DRAWINGS

Fig. 1 is a sectional view for illustrating a manufacturing process of a gain waveguide type LD according to a first embodiment of the invention.
Fig. 2 is a sectional view for illustrating the manufacturing process continued from Fig. 1.
Fig. 3 is a sectional view for illustrating the manufacturing process continued from Fig. 2.
Fig. 4 is a sectional view for illustrating the manufacturing process continued from Fig. 3.
Fig. 5 is a sectional view for illustrating the manufacturing process continued from Fig. 4.
Fig. 6 is a sectional view for illustrating the manufacturing process continued from Fig. 5.
Fig. 7 is a sectional view for illustrating the manufacturing process continued from Fig. 6.
Fig. 8 is a sectional view for illustrating the manufacturing process continued from Fig. 7.
Fig. 9 is a sectional view for illustrating a manufacturing process of a ridge waveguide type LD according to a second embodiment of the invention.
Fig. 10 is a sectional view for illustrating the manufacturing process continued from Fig. 9.
Fig. 11 is a sectional view for illustrating the manufacturing process continued from Fig. 10.
Fig. 12 is a sectional view for illustrating the manufacturing process continued from Fig. 11.
Fig. 13 is a sectional view for illustrating the manufacturing process continued from Fig. 12.
Fig. 14 is a sectional view for illustrating the manufacturing process continued from Fig. 13.
Fig. 15 is a sectional view for illustrating the manufacturing process continued from Fig. 14.
Fig. 16 is a sectional view for illustrating the manufacturing process continued from Fig. 15.
Fig. 17 is a sectional view for illustrating a manufacturing process of a ridge wave guide type LD according to a third embodiment of the invention.
Fig. 18 is a sectional view for illustrating a manufacturing process of a ridge waveguide type LD according to a fourth embodiment of the invention.
Fig. 19 is a sectional view for illustrating a manufacturing process of an LED according to a fifth embodiment of the invention.
Fig. 20 is a sectional view for illustrating a manufacturing process of a field effect transistor according to a sixth embodiment of the invention.
Fig. 21 is a sectional view for illustrating the manufacturing process continued from Fig. 20.

### DETAILED DESCRIPTION OF THE PREFERRED EMBODIMENTS

Embodiments of the present invention will now be described below in detail with reference to the accompanying drawings.

### (First Embodiment)

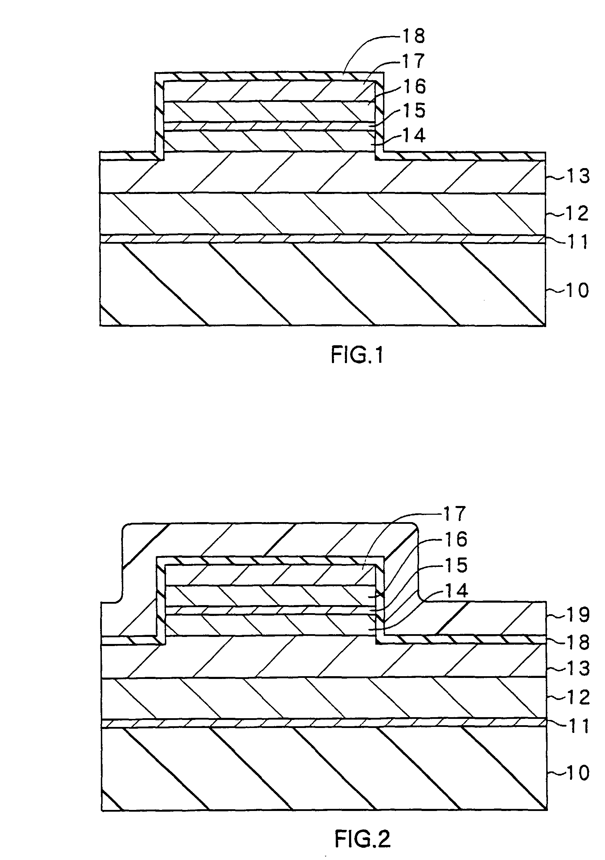

First, reference is made to Fig. 1 to Fig. 8, describing a method of manufacturing a gain waveguide type LD as a method of manufacturing a semiconductor device according to a first embodiment of the invention.

In the embodiment, first, as illustrated in Fig. 1, a substrate 10 made of, for example, sapphire is prepared. On the substrate 10, a buffer layer 11 made of a III-group nitride compound semiconductor is grown by, for example, MOCVD (Metal Organic Chemical Vapor Deposition). An underlying layer 12, an n-side contact layer 13, an n-type cladding layer 14, an active layer 15, a p-type cladding layer 16 and a p-side contact layer 17 (these layers are also called as a semiconductor layer as one layer in the followings) are grown in order using the buffer layer 11 as nuclei. The buffer layer 11, the underlying layer 12, the n-side contact layer 13, the n-type cladding layer 14, the active layer 15, the p-type cladding layer 16 and the p-side contact layer 17 correspond to a specific example of the "semiconductor layer" of the invention. The n-type cladding layer 14 corresponds to a specific example of the "first conductive type cladding layer" of the invention and the p-type cladding layer 16 corresponds to the "second conductive type cladding layer" of the invention.

Specifically, after the buffer layer 11 made of GaN having a crystal structure close to noncrystalline at a temperature of 550°C or AlGaN compound crystal is grown by 30 nm, the underlying layer 12 made of, for example, GaN without doping an impurity at a temperature of 1000°C by 1.5 µm. Subsequently, the n-side contact layer 13 of 4.5 µm thick made of n-type GaN doped with silicon (Si) as an n-type impurity, the n-type cladding layer 14 of 1.0 µm thick made of n-type AlGaN compound crystal doped with silicon as an impurity, the active layer 15 of 0.05 µm thick having a multiple quantum well structure consisted of GaInN compound crystal and GaN, the p-type cladding layer 16 of 0.8 µm thick made of p-type AlGaN compound crystal doped with magnesium (Mg) as a p-type impurity, and the p-side contact layer 17 of 0.1 µm thick made of p-type GaN doped with magnesium (Mg) as an impurity are grown in the order named, for instance.

Examples of material gas for making above-mentioned each layer are as follows; trimethyl aluminum gas ((CH₃)₃Al) for aluminum(Al), trimethyl gallium gas ((CH₃)₃Ga) or trimethyl gallium gas ((C₂H₅)₃Ga) for gallium(Ga), trimethyl indium gas ((CH₃)₃In) for indium(In), ammonia gas (NH₃) for nitrogen(N), monosilane gas (SiH₄) for silicon, and bis-methyl cyclopentadienel magnesium gas (MeCp₂Mg) or bis-cyclopentadienel magnesium gas (Cp₂Mg) for magnesium.

The n-side contact layer 13 is exposed by selectively etching parts of the p-side contact layer 17, the p-type cladding layer 16, the active layer 15, the n-type cladding layer 14 and the n-side contact layer 13. The layers are etched 2 µm in deep, for instance.

Over the entire exposed surface of the semiconductor layer, that is, the surfaces of the n-side contact layer 13 and the p-side contact layer 17, and the sides of the n-side contact layer 13, the n-type cladding layer 14, the active layer 15, the p-type cladding layer 16 and the p-side contact layer 17, an insulating layer 18 made of an insulating material having etching resistivity such as silicon dioxide (SiO₂) or silicon nitride (Si₃N₄) is formed by, for example deposition, ECRCVD (Electron Cyclotron Resonance Chemical Vapor Deposition) or ECR sputtering. The insulating layer 18 corresponds to a specific example of the "protective layer" of the invention. Deposition, ECRCVD, or ECR sputtering reducing or eliminating damage caused by plasma during deposition to the top layer of the semiconductor layer is used to form the insulating layer 18. As a result, the area close to the insulating layer 18 suffers less damage compared to the case using heat-CVD, PE (Plasma Enhanced) CVD or general sputtering. This prevents a decrease in the carrier density of the p-side contact layer 17 and the p-type cladding layer 16 caused by damage.

As illustrated in Fig. 2, a resist film 19 of 1 µm thick is formed over the entire surface of the insulating layer 18 by, for example, spin coating. The resist film 19 corresponds to a specific example of the "mask layer" of the invention.

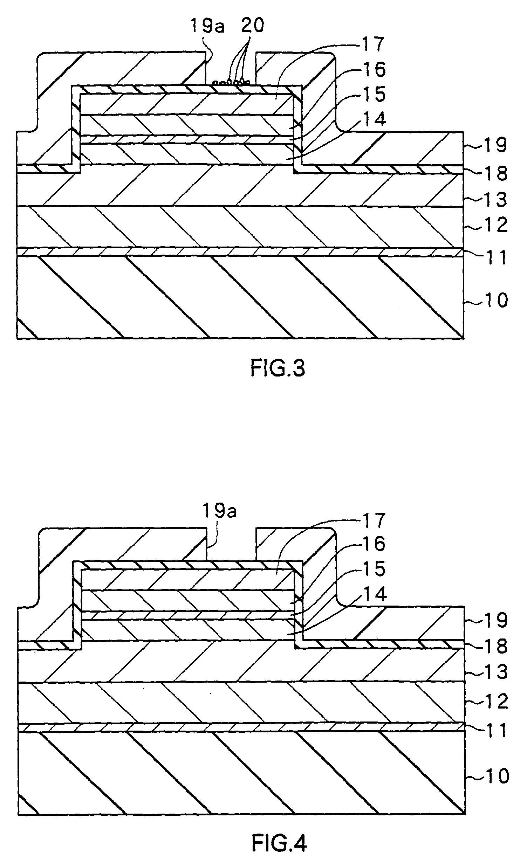

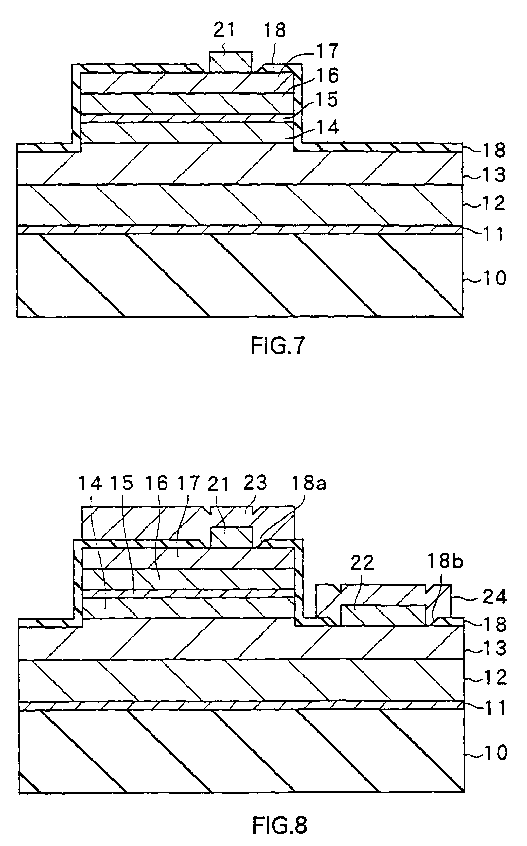

As illustrated in Fig. 3, an opening 19a corresponding to a pattern of a p-side electrode 21 (See Fig. 7), which is described later, is formed in the resist film 19 by, for example, photolithography. Specifically, ultraviolet rays is irradiated to the resist film 19 for approximately 10 seconds in 1m W/cm³ in output by using high pressure mercury lamp. After that, the resist film 19 is developed for approximately 30 seconds at a temperature of 20°C by using an inorganic phosphate base developing solution. At this time, the developing portion of the resist film 19 is incompletely removed; therefore a residue 20 may attach inside the opening 19a.

To remove the residue 20, a light ashing treatment is applied for 3 minutes at a room temperature by using, for example, oxygen plasma after developing. As illustrated in Fig. 4, the residue 20 is removed without changing the shape of the resist film 19. The light ashing treatment is the treatment that ashing a small amount of attached residue 20 in a weak condition, for example, the condition that the etching rate of the resist film 19 is equal to or less than 0.05 µm per minute, whereby lower energy and the setting temperature of oxygen plasma. In the ashing treatment, as the semiconductor layer is protected by the insulating layer 18, the surface of the semiconductor layer suffers no damage. This also prevents a decrease in the carrier density of the p-side contact layer 17 and the like.

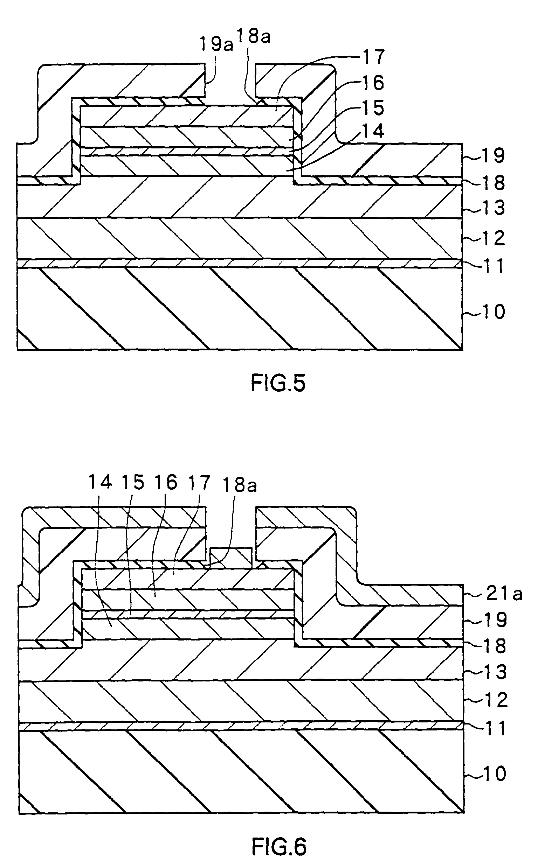

As illustrated in Fig. 5, the insulating layer 18 is etched to reach the p-side contact layer 17 with, for example, hydrofluoric acid base etching liquid by using the resist film 19 as a mask. An opening 18a is formed in the area of the insulating layer 18 corresponding to the opening 19a. Since the residue 20 attaching to the opening 19a is completely removed, no residue is attached to the surface of the p-side contact layer 17 by moving the residue of the resist film 19 through etching liquid.

As illustrated in Fig. 6, a nickel film or a platinum film is grown over the entire surface, that is, on the p-side contact layer 17 and the resist film 19 selectively removed the insulating layer 18 by, for example, deposition. After that, a metal layer 21a is formed by depositing an appropriate metal, for example, gold film. Nickel or platinum using for the material to form the metal layer 21a can obtain a good ohmic contact with III-group nitride compound. The exposed surface of the p-side contact layer 17 is completely covered with the metal layer 21a or is slightly exposed, for example, in a width of 1 µm or less in the area close to a side wall of the opening 18a in the insulating layer 18 as illustrated in the figure.

As illustrated in Fig. 7, the resist film 19 is removed by using an organic solvent such as acetone. Simultaneously, the portion of the metal layer 21a making contact with the resist film 19 is selectively removed (lift-off), and consequently only the portion of the metal layer 21a making contact with the p-side contact layer 17 remains. The remained metal layer 21a is alloyed by a heat treatment and the p-side electrode 21 is completed. Further, the p-side electrode 21 is patterned to be a striped shape (in Fig. 7, a striped shape extended to the direction perpendicular to the paper) to confine light into only part of the active layer 15 during the operation of an LD.

As illustrated in Fig. 8, a resist film (not shown) is applied over the entire surface, that is, on the insulating layer 18 and the p-side electrode 21, and an opening 18b is formed on the n-side contact layer 13 of the insulating layer 18 as in the process of forming the opening 18a. Subsequently, over the entire surface, that is, on the n-side contact layer 13 selectively removed the insulating layer 18 and the resist film, titanium, aluminum, platinum and gold are evaporated in order, whereby an n-side electrode 22 is formed as in the process of forming the p-side electrode 21.

An contact electrode 23 is formed by selectively evaporating, for example, titanium and gold in order on the p-side electrode 21 and the insulating layer 18 around the p-side electrode 21. Simultaneously, an contact electrode 24 is formed on the n-side electrode 22 and the insulating layer 18 around the n-side electrode 22. The contact electrodes 23 and 24 reinforce the adhesibility of the p-side electrode 21 and the n-side electrode 22, respectively. The contact electrodes 23 and 24 are also used as a electrode for mounting, that is, a electrode for a bonding pad and die bonding to a package to mount the completed LD on a package.

Finally, the substrate 10 is cleaved with a predetermined width in a direction perpendicular to the direction lengthwise (the direction lengthwise of cavity) of the p-side electrode 21. Using the cleaved surface of the substrate 10 as a mirror, a gain waveguide type LD is completed. The cleaved surface may be coated for controlling reflectance as the need arises.

In the gain waveguide type LD manufactured as described above, current is injected into the active layer 15 when a certain voltage is applied between the p-side electrode 21 and the n-side electrode 22 through the contact electrodes 23 and 24. The current is narrowed by the insulating layer 18. In the active layer 15, light emitting caused by the recombination of the electron-hole occurs, and light is emitted outside through the mirror. The surfaces of the p-side contact layer 17 and the n-side contact layer 13 suffer no damage in manufacturing. As a result, the p-side contact layer 17 and the p-side electrode 21, and the n-side contact layer 13 and the n-side electrode 22 are in good ohmic contact each other, respectively. Thus, stable contact resistance can be obtained. This allows an LD to operate in stable voltage.

In the embodiment, the residue 20 attached to the resist film 19 and the opening 19a is removed with the semiconductor layer protected by the insulating layer 18. This suppresses damage to the surface of the semiconductor layer. Accordingly, a deterioration in the carrier density of the p-side contact layer 17 and the p-type cladding layer 16 is prevented, and thus stable contact resistance can be obtained between the p-side electrode 21 and the p-side contact layer 17. Also, an increase in contact resistance between the n-side electrode 22 and the n-side contact layer 13 is prevented. Damage to the surface of the semiconductor layer is suppressed by forming the insulating layer 18 by deposition, ECRCVD or ECR sputtering. In addition, a deterioration in the carrier density of the p-side contact layer 17 and the n-side contact layer 13 can be prevented.

The opening 18a is formed in the insulating layer 18 after the residue 20 attached to the opening 19a in the resist film 19 is removed. As a result, no residue is attached on the surface of the p-side contact layer 17 by moving the residue in the resist into etching liquid during the formation of the opening 18a. This enables to form the p-side electrode 21 on the clean surface of the p-side contact layer 17 and to improve adhesibility between the p-side contact layer 17 and the p-side electrode 21. Consequently, this prevents the p-side electrode 21 from peeling off during the manufacturing process or mounting to a package.

The p-side electrode 21 and the n-side electrode 22 are covered with the contact electrodes 23 and 24, respectively so that adhesibility between the p-side electrode 21 and the n-side electrode 22 can be increased. As a result, the p-side electrode 21 can be made of a material having a good ohmic contact such as nickel, platinum or the like. This enables to reduce contact resistance and to prevent electrode from peeling off. In addition, quality and reliability of the device are improved.

The insulating layer 18 is formed over the surfaces of the n-side contact layer 13 and the p-side contact layer 17, and the sides of the n-side contact layer 13, the n-type cladding layer 14, the active layer 15, the p-type cladding layer 16 and the p-side contact layer 17. This reduces parasitic capacity as compared to the case where the insulating layer 18 is formed only on the surfaces of the n-side contact layer 13 and the p-side contact layer 17. As a result, an LD of excellent high-frequency characteristics is manufactured.

The insulating layer 18 is formed to cover a pn junction surface, that is, the sides of the active layer 15. This suppresses a electrical short circuit in wicking solder during mounting on a package. Thus, a high reliability mounting condition can be obtained.

Formation of the p-side electrode 21 by self-aligning using the resist film 19 as a mask allows a reduction in the manufacturing processes.

### (Second Embodiment)

The present embodiment discloses a method of manufacturing a ridge waveguide type LD, which is of the combined gain waveguide type and refractive index waveguide type. Description is made by referring to Fig. 1 to Fig. 7 and Fig. 9 to Fig. 16.

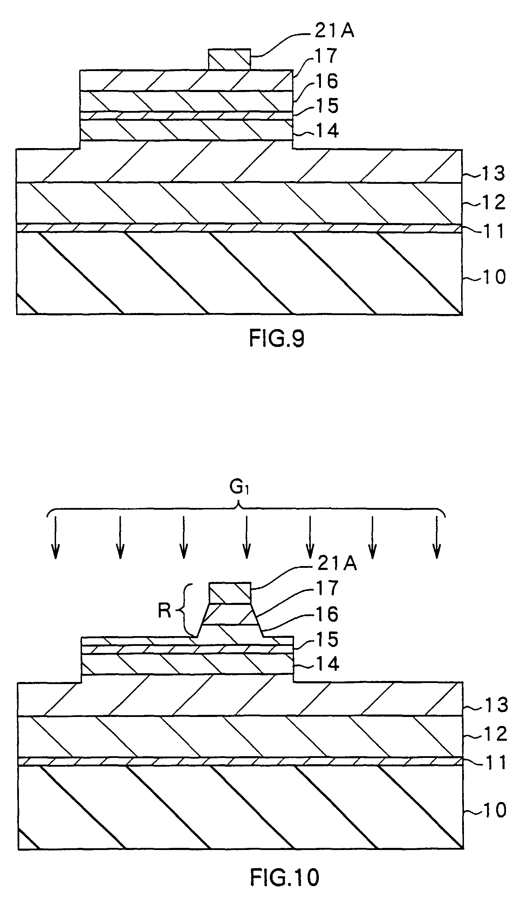

In the embodiment, first, as illustrated in Fig. 9, a stripe-shaped p-side electrode 21A is formed through the opening 18a of the insulating layer 18 on the semiconductor layer formed on the substrate 10 like the steps illustrated in Fig. 1 to Fig. 7 of the first embodiment. The embodiment requires to suppress the etching of the p-side electrode 21A not to influence on a electrode characteristics in order to use the p-side electrode 21A as a etching mask as described later. Preferably, the top surface of the p-side electrode 21A is made of nickel or platinum having the greater selective etching ratio with III-group nitride compound semiconductors than that of gold. An example of such structure of the p-side electrode 21A is that platinum, gold and nickel, or nickel, platinum, gold and nickel are stacked on the p-side contact layer 17 in the order named.

As illustrated in Fig. 10, parts of the p-side contact layer 17 and the p-type cladding layer 16 are selectively etched by, for example, RIE (Reactive Ion Etching) with chlorine gas (Cl₂) G₁ used as reactant gas by using the p-side electrode 21A as a mask after removing the insulating layer 18 by etching with, for example, hydrofluoric acid base etching liquid. With this step, the p-type cladding layer 16 is exposed by self-aligning and the ridge R consisted of the upper part of the p-type cladding layer 16, the p-side contact layer 17 and the p-side electrode 21A is formed.

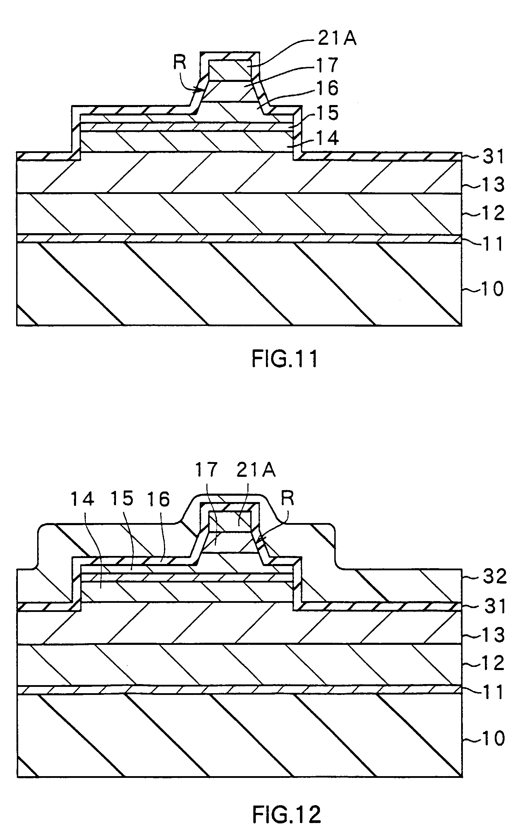

As illustrated in Fig. 11, an insulating layer 31 made of silicon dioxide having a refractive index of 1.46 is formed over the entire exposed surface, that is, the surfaces of the n-side contact layer 13, the p-type cladding layer 16 and the p-side electrode 21A, and the sides of the ridge R, by, for example, deposition.

As illustrated in Fig. 12, a resist film 32 is formed over the entire surface of the insulating layer 31 by, for example, spin coating. The thickness of the resist film 32 on the top surface of the p-side electrode 21A is thinner than the resist film 32 formed on the rest of the area. Specifically, if the total heights (thickness) of the ridge R and the insulating layer 31 is 1 µm, the resist film 32 on the top surface of the p-side electrode 21A is formed to be 0.5 to 0.8 µm thick, for instance.

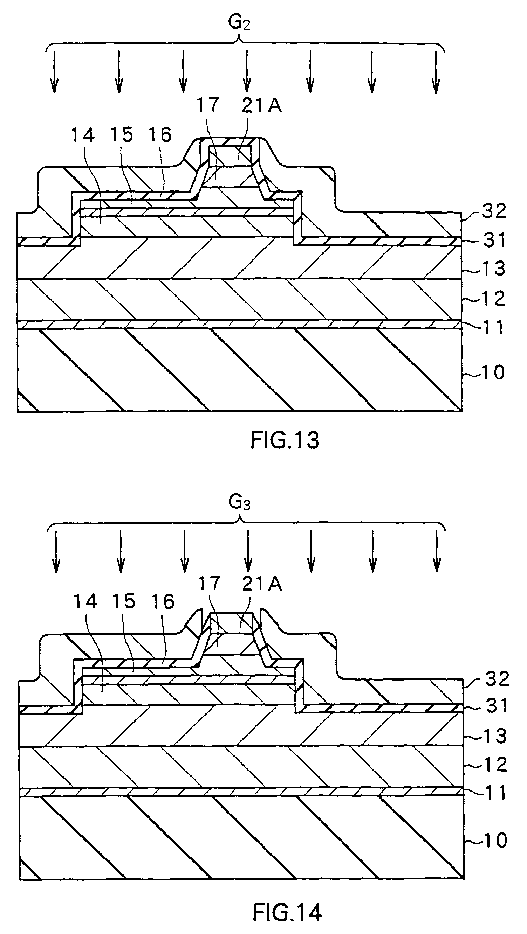

As illustrated in Fig. 13, the area of the resist film 32 corresponding to the ridge R is selectively removed by, for example, RIE with oxygen gas (O₂) G₂ used as reactant gas and then the insulating layer 31 is exposed. As described, the thickness of the resist film 32 on the top surface of the p-side electrode 21A is thinner than the resist film 32 formed on the rest of the area. This enables to remove only the resist film 32 formed on the upper part of the area corresponding to the ridge R.

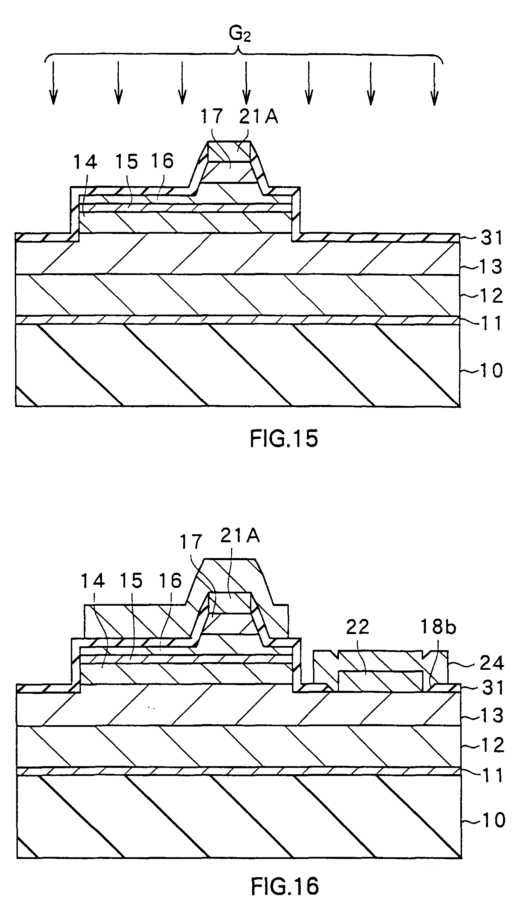

As illustrated in Fig. 14, the exposed surface of the insulating layer 31 is selectively removed by, for example, RIE with carbon tetrafluoride gas (CF₄) G₃ used as reactant gas and then the p-side electrode 21A is exposed. Next, as illustrated in Fig. 15, the resist film 32 is removed by, for example, RIE with oxygen gas G₂ used as reactant. With this step, the area except the surface of the p-side electrode 21A is covered with the insulating layer 31.

As illustrated in Fig. 16, the n-side electrode 22, the contact electrodes 23 and 24 are formed as in, for example, the method of the first embodiment. After that, the substrate 10 is cleaved with a predetermined width in a direction perpendicular to the direction lengthwise of the p-side electrode 21. Using the cleaved surface of the substrate 10 as a mirror, the ridge waveguide type LD is completed.

The ridge waveguide type LD manufactured as described above perform like the gain waveguide type LD of the first embodiment. In the ridge waveguide type LD, the ridge R is covered with a layer made of a material having the greater refractive index than the ridge R, that is, the insulating layer 18 in the embodiment. As a result, the ridge waveguide type LD can confine light effectively. In the ridge R, the refractive indices of the p-side electrode 21A, the p-side contact layer 17, and the p-type cladding layer 16 are 1.64, 2.53, and 2.49, respectively, for instance.

In the embodiment, using the p-side electrode 21 as a mask, the p-side contact layer 17 and the p-type cladding layer 16 are formed to be ridge-shaped by self-aligning. This reduces the manufacturing processes of a ridge waveguide type LD.

Furthermore, the sides of the ridge R are covered with the insulating layer 31 made of a material having the smaller refractive index than the material making the ridge R. This gives a difference in refractive index in the direction of the width of the active layer 15. In addition, the electrical conduction width of the p-side contact layer 17 and the p-side electrode 21A is the same as the width of the p-side electrode 21A. As a result, light confinement effect can be increased.

### (Third Embodiment)

The present embodiment relates to a method of manufacturing a ridge waveguide type LD using a substrate made of a conductive material.

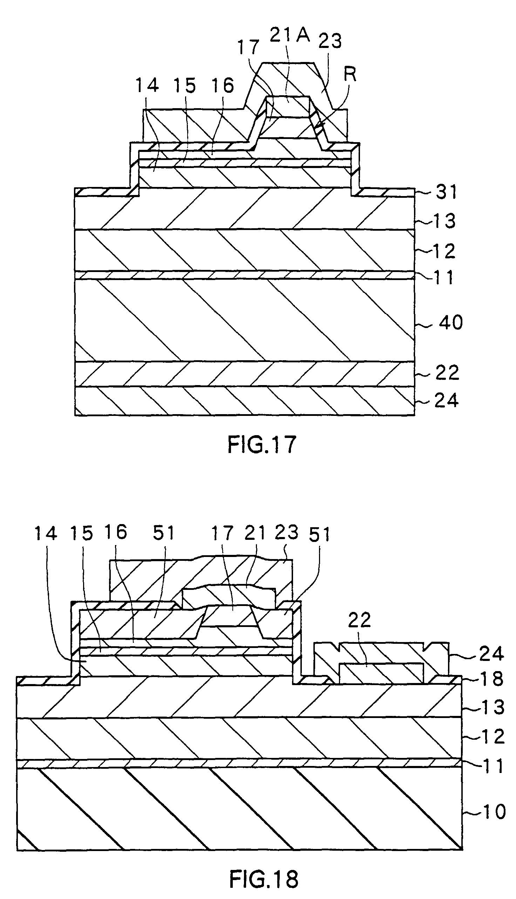

In the embodiment, firstly, a conductive substrate 40 (see Fig. 17) made of, for example, GaN or SiC (silicon carbide) is prepared. On the conductive substrate 40, formed are a semiconductor layer having the ridge R and the p-side electrode 21A as in, for example, the process of the first or second embodiment illustrated in Fig. 1 to Fig. 7 and Fig. 9 to Fig. 15.

As illustrated in Fig. 17, over the p-side electrode 21A and the insulating layer 31 around the p-side electrode 21A, the contact electrode 23 is formed through selectively depositing, for example, titanium and gold. Next, on the rear side of the conductive substrate 40, the n-side electrode 22 and the contact electrode 24 are formed in order. Lastly, the conductive substrate 40 is cleaved with a predetermined width in a direction perpendicular to the direction lengthwise of the p-side electrode 21A. The n-side electrode 22 may be uniform all over the surface thereof or have a pattern to designate the positions of bars or chips of an LD.

### (Fourth Embodiment)

In a method of manufacturing a ridge waveguide type LD according to the present embodiment, as illustrated in Fig. 18, the semiconductor layer is deposited over the substrate 10 as in the process of the first embodiment illustrated in Fig. 1. Then, part of the p-side contact layer 17 and the p-side cladding layer 16 is selectively etched into the ridge-shaped, while the p-side cladding layer 16 is exposed.

Next, by, for example, MOCVD, over the exposed surface of the p-type cladding layer 16, a re-grown layer 51 is formed so as to surround the ridge of the p-type contact layer 17 and the p-type cladding layer 16. The re-grown layer 51 is made of a III-group nitride compound semiconductor having a refractive index smaller than those of the p-side cladding layer 16 and the p-side contact layer 17, such as GaInN or AlGaN. The re-grown layer 51 is formed so that the surface thereof contains a plane common with the surface of the p-side contact layer 17.

The re-grown layer 51 can be formed with, for example, either one of process described below. One is selective growth technique. In the technique, GaInN or the like is selectively re-grown on the exposed surface of the p-type cladding layer 16 after forming an insulating layer made of silicon dioxide, silicon nitride or the like on the area except the exposed surface of the p-type cladding layer 16. According to the technique, although the kind of re-growing crystal and growth condition are limited, the re-grown layer 51 can be obtained in desired shape at the time of re-growing. The other method is removing unnecessary parts after re-growing GaInN or the like over the entire surface of the substrate 60. According to the method, the kind of re-growing crystal and growth condition are comparatively free to decide; however, the exposing process of the p-side contact layer 17 is required.

Then, the insulating layer 18, the p-side electrode 21, the n-side electrode 22 and the contact electrodes 23 and 24 are formed as in the process of the first embodiment illustrated in Fig. 1 to Fig. 8.

Although it is not shown in the figure, after the re-grown layer 51 is formed, a p-side contact layer is grown again on the p-side contact layer 17 and the re-grown layer 51. The contact area between the p-side contact layer and the p-side electrode may be increased to decrease contact resistance.

According to the embodiment, after the re-grown layer 51 is formed on the sides of the p-side contact layer 17 to be substantially flush with the p-side contact layer 17, the p-side electrode 21 and the contact electrode 23 are formed. As a result, the surface of the ridge wave guide type LD is more planarized than that of the second and the third embodiments. This enables to improve heat resistive characteristics in mounting on a package, adhesibility with solder materials or the like, and reliability in mounting.

### (Fifth Embodiment)

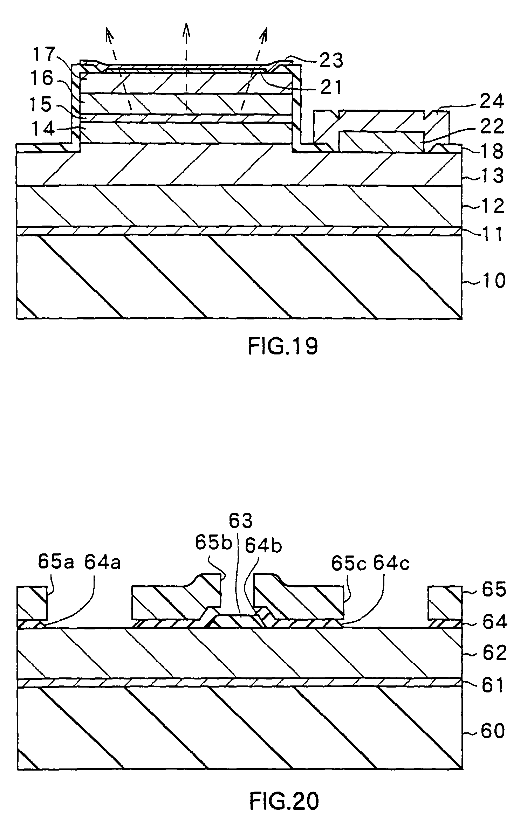

The fifth embodiment of the present invention relates to a method of manufacturing an LED. In the present embodiment, as illustrated in Fig. 19, the p-side electrode 21 and the contact electrode 23 are formed with small thicknesses so that a sum of the thicknesses thereof is about 5 to 15 nm. The p-side electrode 21 and the contact electrode 23 are also formed so that a contact area between the p-side electrode 21 and the p-side contact layer 17 is large. In addition, the substrate 10 is not cleaved. Otherwise, the p-side electrode 21 and the contact electrode 23 are formed as in the first embodiment. In the LED, the p-side electrode 21 and the contact electrode 23 are formed with small thicknesses, making it possible to allow light emitted from the upper side of the substrate 10, i.e., the p-side electrode 21 side, as indicated by the arrow in Fig. 19. Obviously, the substrate 10 can be configured to allow light emitted from the rear side thereof, if the substrate 10 allows the wavelength of light emitted to transmit therein.

### (Sixth Embodiment)

The present embodiment discloses a method of an FET (Field Effect Transistor).

In the embodiment, first, as illustrated in Fig. 20, a substrate 60 made of, for example, sapphire is prepared. On the substrate 60, after a buffer layer 61 made of, for example, GaN having a crystal structure close to noncrystalline at a temperature of 550°C or AlGaN compound crystal is grown by 30 nm, a channel layer 62 made of, for example, n-type GaN doped with silicon as an n-type impurity at a temperature of 1000°C is grown. Further, a gate insulating film 63 made of AlN or AlₓGa₁₋ₓN (x<1) having a great composition ratio x of aluminum is grown continuously. The gate insulating film 63 may be formed of other insulating materials such as silicon dioxide. The buffer layer 61 and the channel layer 62 correspond to a specific example of the "semiconductor layer" of the invention.

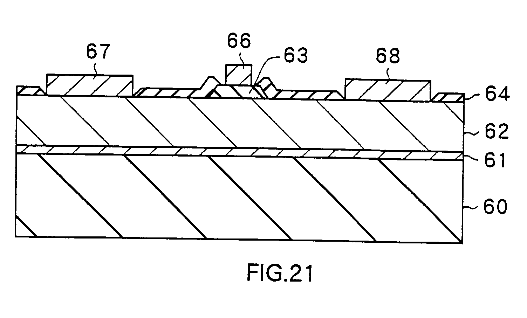

Part of the gate insulating film 63 except the area corresponding to a gate electrode 66, which is described later (see Fig. 21), is removed with, for example, alkaline solution such as potassium hydroxide (KOH) aqueous solution or the like. Subsequently, over the entire exposed surface, that is, the surface of the channel layer 62, and the surface and sides of the insulating film 63, an insulating layer 64 made of an insulating material having etching resistivity, for example, silicon dioxide or silicon nitride is formed by, for example deposition, ECRCVD or ECR sputtering. The insulating layer 64 corresponds to a specific example of the "protective layer" of the invention.

On the entire surface of the insulating layer 64, a resist film 65 is formed by, for example, spin coating. The resist film 65 corresponds to a specific example of the "mask layer" of the invention. The openings 65a, 65b, and 65c corresponding to the pattern of the gate electrode 66, a source electrode 67 and a drain electrode 68, which are described later (see Fig. 21) are respectively formed in the resist film 65 as in the process of the first embodiment illustrated in Fig. 3 to Fig. 5. After the residue attached to the inside of the openings 65a, 65b and 65c (not shown) is removed, the openings 64a, 64b and 64c corresponding to the openings 65a, 65b and 65c are respectively formed in the insulating layer 64.

After forming a metal layer by stacking titanium (Ti), platinum (Pt) and gold (Au) on the channel layer 62 in order by, for example, deposition over the entire surface of the substrate 60, the resist film 65 is removed as illustrated in Fig. 21. Simultaneously, part of the metal layer making contact with the resist layer 65 is selectively removed and the rest of the metal layer become the gate electrode 66, the source electrode 67 and the drain electrode 68.

In the FET manufactured as mentioned above, application of voltage to the gate electrode 66 changes drain current feeding between the source electrode 67 and the drain electrode 68 through the gate electrode 66. This suppresses damage to the surface of the channel layer 62 making contact with the source electrode 67 and the drain electrode 68 in the manufacturing process. The source electrode 67 and the drain electrode 68 are in good ohmic contact with the channel layer 62, respectively and thus stable contact resistance can be obtained.

In the embodiment, like the first embodiment, the contact resistance between the source electrode 67 and the drain electrode 68, and the channel layer 62 can be reduced and adhesibility between the source electrode 67 and the drain electrode 68 is improved. As a result, quality and reliability of the device are improved. This enables to form the gate electrode 66 on the clean surface of the gate insulating layer 63 and to ensure good characteristics.

Although the invention has been described by some embodiments, the invention is not limited to the foregoing embodiments but can be variously modified. For example, in the above-mentioned embodiments, although both the surface and the sides of the semiconductor layer are protected by the insulating layer 18 in the removal of the residue 20, only the surface of the semiconductor layer may be protected. However, considering a reduction in parasitic capacity, it is preferable to form the insulating layer 18 on the sides of the semiconductor layer as well. The semiconductor layer may be protected by the metal layer made of a metal material capable of depositing without causing damage to the surface of the semiconductor layer by, for example, deposition and of selectively etching the resist film 19 and the semiconductor layer such as aluminum and titanium. In this case, the metal layer needs to be removed after forming the p-side electrode 21 or the n-side electrode 22, because the metal layer makes electrical short circuit when device has the metal layer. Further, the protective layer may be formed of a combination material of an insulating material and a metal material.

In the above-mentioned embodiments, the semiconductor layer is comprised of a III-group nitride compound semiconductor, while the present invention may be applied to manufacture semiconductor devices having semiconductor layers comprised of other semiconductors.

In the second and the third embodiments described above, the p-side contact layer 17 and the p-type cladding layer 16 are formed to be ridge-shaped by self-aligning using the p-side electrode 21A as a mask. However, the p-side electrode 21A may be formed after forming the p-side contact layer 17 and the p-type cladding layer in ridge-shaped. In this case, the p-side electrode 21A can be formed regardless of the height of ridge and the width of stripe of the p-side electrode 21A. Also, the surface of the substrate 60 may not be necessarily planarized in forming the p-side electrode 21A. This extends the range of choices of the process order. For example, it is possible to form the p-side electrode 21A after forming the n-side electrode 22. In this case, the process order can be decided in consideration of heat treatment condition or the like.

In the above-mentioned embodiments, an LD, an LED and an FED are given as an example of a semiconductor device. The present invention is widely applied to manufacture other semiconductor devices using to form an emitter electrode, a base electrode and a collector electrode for bipolar transistor, an electrode for a photodiode and so on. The invention is also applied to manufacture an integrated device integrates above-mentioned devices.

In the above-mentioned embodiments, the p-side electrodes 21 and 21A are formed to be striped shape. However, the n-type layer and the p-type layer corresponding each other may be positioned reversely with the n-side electrode 22 forming in striped shape.

Moreover, in the above-mentioned embodiments, although the residue 20 is removed by ashing treatment using oxygen, the residue 20 may be removed by wet etching using alkaline etching liquid or the like. In this case, the surface of the semiconductor layer suffers no damage. However, the resist film 19 is easily removed by alkaline etching liquid, with the result that selectivity with the resist film 19 is limited. Uneven surface makes it difficult to treat the concave portion on the surface.

As described, according to a method of manufacturing a semiconductor device of the invention, while the semiconductor layer is protected by the protective layer, the residue attached to the opening in the mask layer is removed. Subsequently, the opening is formed in the protective layer using the mask layer and the electrode is formed. This suppresses damage to the surface of the semiconductor layer in the removal of the residue. This also enables to form the electrode on the clean exposed surface of the semiconductor layer by self-aligning. As a result, adhesibility between the semiconductor layer and the electrode can be improved by easy process and contact resistance therebetween is reduced.

Especially, according to a method of manufacturing a semiconductor device of the invention, the protective layer is formed to cover the top surface and sides of the semiconductor layer. This enables to reduce parasitic capacity compared to the case where the protective layer is formed only in the top surface of the semiconductor layer. As a result, the semiconductor device having excellent high-frequency characteristics can be manufactured.

Obviously many modifications and variations of the present invention are possible in the light of the above teachings. It is therefore to be understood that within the scope of the appended claims the invention may be practiced otherwise than as specifically described.

## Claims

1. A method of manufacturing a semiconductor device comprising a semiconductor layer and an electrode making contact with the semiconductor layer, the method including steps of:
forming a protective layer made of an etching resistant material, at least over a top surface of the semiconductor layer;
forming a mask layer over a top surface of the protective layer and then forming an opening in the mask layer, the opening corresponding to a pattern of the electrode;
removing residue generated when forming the opening in the mask layer and attached inside the opening, while the semiconductor layer is protected by the protective layer;
selectively removing an area of the protective layer by using the mask layer, the area corresponding to the opening, thereby selectively exposing the semiconductor layer; and
forming the electrode on the exposed surface of the semiconductor layer by using the mask layer.

2. A method of manufacturing a semiconductor device according to claim 1, wherein residue is removed through an ashing treatment using oxygen.

3. A method of manufacturing a semiconductor device according to claim 1, wherein the protective layer is made of an insulating material.

4. A method of manufacturing a semiconductor device according to claim 3, wherein the protective layer is made of silicon dioxide or silicon nitride.

5. A method of manufacturing a semiconductor device according to claim 3, wherein the protective layer is made of aluminum.

6. A method of manufacturing a semiconductor device according to claim 3, wherein the protective layer is formed so as to spread over a top surface and sides of the semiconductor layer.

7. A method of manufacturing a semiconductor device according to claim 1, wherein the protective layer is formed by deposition, electron cyclotron resonance sputtering or electron cyclotron resonance chemical vapor deposition.

8. A method of manufacturing a semiconductor device according to claim 1, wherein the semiconductor layer is made of a III-group nitride compound semiconductor including nitrogen (N) and at least one III-group element selected from the group consisting of gallium (Ga), aluminum (Al), indium (In) and boron (B).

9. A method of manufacturing a semiconductor device according to claim 1, wherein the electrode is made of a metal including at least one selected from the group consisting of nickel (Ni) and platinum (Pt).

10. A method of manufacturing a semiconductor device according to claim 1, wherein the semiconductor layer comprises a plurality of semiconductor layers including at least a first conductive type cladding layer, an active layer and a second conductive type cladding layer stacked one upon another, and the first conductive type cladding layer, the active layer and the second conductive cladding layer are electrically connected to the electrode in the step of forming the electrode, thereby forming a semiconductor light emitting device.

11. A method of manufacturing a semiconductor device according to claim 1, wherein the electrode is a source electrode or a drain electrode of a transistor.
